**Europäisches Patentamt**

**European Patent Office**

**Office européen des brevets**

(19)

(11) Veröffentlichungsnummer: **0 240 781**

**A2**

(12) # EUROPÄISCHE PATENTANMELDUNG

(21) Anmeldenummer: **87103847.7**

(22) Anmeldetag: **17.03.87**

(51) Int. Cl.⁴: **H01L 29/60 , H01L 29/78 , H01L 21/285 , H01L 27/08**

(30) Priorität: **08.04.86 DE 3611758**

(43) Veröffentlichungstag der Anmeldung:
**14.10.87 Patentblatt 87/42**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Enders, Gerhard, Dipl.-Phys.**
**Stüdlstrasse 5**
**D-8000 München 50(DE)**
Erfinder: **Mohr, Ernst-Günther, Dipl.-Phys.**
**Erich-Kästner-Strasse 10**
**D-8000 München 40(DE)**

(54) **Verfahren zum Herstellen von Flankenmaskierschichten an den Gate-Elektroden von MOS-Transistoren mit schwach-dotierten Drain-Anschlussgebieten.**

(57) Die Herstellung der aus Silizium bestehenden Flankenmaskierschichten (11a, 11b) (2. spacer) erfolgt nach der Strukturierung der Gate-Elektroden ( 7, 8) durch ganzflächige Abscheidung einer Siliziumschicht aus der Gasphase auf die vorher mit einer Oxidschicht (16, 17, 18) bedeckten Gates (7, 8) und Source/Drain-Diffusionsbereiche (13, 14) und Rückätzen der Siliziumschicht bis auf die an den Flanken der Gatestrukturen (7, 8) verbliebenen SiliziumÄtzresiduen (11a, 11b). Diese Siliziumspacer (11a, 11b) haben gegenüber den bekannten Oxidspacern den Vorteil, daß bei ihrer Erzeugung keine Dünnung des Feldoxids (3) und keine Schädigung des Siliziumsubstrates (1, 4, 5, 9) auftritt. Durch das Verfahren nach der Lehre der Erfindung ist die Möglichkeit gegeben, bei der Herstellung von CMOS-Schaltungen die Kanallängen und die Source/Drain-Diffusionsprofile der n-und p-Kanal-Transistoren unabhängig voneinander einzustellen, indem der Siliziumspacer (11a, 11b) nach der n⁺-Implantation (13) entfernt wird und so der spacer (11a, 11b) nur für die n-KanalTransistoren genutzt wird. Figur 5

FIG 5

## Verfahren zum Herstellen von Flankenmaskierschichten an den Gate-Elektroden von MOS-Transistoren mit schwach-dotierten Drain-Anschlußgebieten.

Die Erfindung betrifft ein Verfahren zum Herstellen von die Unterdiffusion der implantierten Source/Drain-Bereiche unter die Gateflächen vermindernden Flankenmaskierschichten (spacer) an den Gate-Elektroden von n-bzw. p-Kanal-MOS-Transistoren mit schwach-dotierten Drain-Anschlußgebieten (lightly doped drain = LDD).

Die Erfindung betrifft ferner ein Verfahren zum Herstellen von optimierten komplementären MOS-Feldeffekttransistoren (CMOS-Transistoren) in VLSI-Technik (= very large scale integration-Technik), bei dem für die Aufnahme der n-bzw. p-Kanal-Transistoren der Schaltung im Siliziumsubstrat p-bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Photolackstrukturen erfolgt, bei dem weiterhin zur Verminderung der Unterdiffusion der implantierten Source/Drain-Bereiche unter die Gatefläche die Gate-Elektroden mit einer Flankenmaskierschicht versehen werden und bei dem die Herstellung der Source/Drain-und Gate-Bereiche, sowie die Erzeugung des Zwischen-und Isolationsoxids und der Kontaktmetallebene nach bekannten Verfahrensschritten der MOS-Technologie vorgenommen wird.

Mit zunehmender Integrationsdichte von MOS-Bausteinen und damit abnehmender Kanallänge der Transistoren im Bereich von 1 μm gefährden sogenannte "hot-electron-Effekte", induziert durch die am Drain auftretenden hohen Feldstärken, die Langzeitzuverlässigkeit der Bauelemente; insbesondere wird die Schaltgeschwindigkeit beeinträchtigt.

Zur Unterdrückung dieser Effekte werden MOS-Feldeffekttransistoren mit geeignet eingestellten Profil der Source/Drain-Diffusion vorgeschlagen. Über einen sogenannten "Source/Drain-pullback", wie in der europäischen Patentanmeldung 0 159 617 und auch in einem Bericht von K. Ohta et. al. im IEEE ED-27 (1980) auf den Seiten 1352 bis 1358 beschrieben, läßt sich die Source/Drain-Diffusion gegen die Gatekante rückversetzen, um so eine Reduktion der Überlappkapazitäten zu erhalten.

Transistoren mit einem nieder-dotierten Anschlußbereich zum Kanal, wie die als lightly doped drain (LDD) bezeichneten Transistoren, die in einem Bericht von S. Ogura et. al. im IEEE ED-27 (1980), auf den Seiten 1359 bis 1367 beschrieben sind, führen zu verbesserten punchthrough-Verhalten und zu einer deutlichen Verringerung der hot-electron-Effekte.

Ein Verfahren der eingangs genannten Art ist beispielsweise aus der europäischen Patentanmeldung 0 123 182 bekannt. Bei diesem Verfahren wird die Unterdiffusion der MOS-Transistorgates durch ein Zurückziehen (pull back) von der Gatekante dadurch zu verhindern versucht, daß vor der Source/Drain-Implantation mit hoher Dosis ein sidewall-spacer-Oxid an den Polysilizium-Gates gebildet wird.

Die Herstellung der sidewall-spacer-Oxide kann durch Reoxidation der Polysiliziumgates oder durch konforme Abscheidung von $SiO_2$ aus der Gasphase und anisotropes Rück ätzen der Oxidschicht erfolgen. Störende Effekte bei diesen Verfahren sind:

1. das die aktiven Transistorbereiche trennende Feldoxid wird in der Überätzphase der spacer-Erzeugung gedünnt und

2. die Schädigung des Siliziumsubstrates in der Überätzphase bei der Herstellung der spacer ist unvermeidlich.

Aufgabe der Erfindung ist es daher, einen Flankenmaskierprozeß (spacer-Erzeugung) anzugeben, der diese Nachteile nicht aufweist. Desweiteren ist es auch Aufgabe der Erfindung, den Flankenmaskierprozeß für die Herstellung von CMOS-Transistoren zu nutzen und insbesondere Maßnahmen zu treffen, welche die Möglichkeit der unabhängigen Optimierung von n-und p-Kanal-Transistoren zulassen.

Diese Aufgabe wird durch ein Verfahren der eingangs genannten Art dadurch gelöst, daß

a) nach der Strukturierung der Gate-Elektroden ganzflächig eine thermische Oxidation durchgeführt wird, wobei die Gate-und die späteren Source/Drain-Diffusionsbereiche der MOS-Transistoren mit einer Oxidschicht versehen werden,

b) ganzflächig auf der Oxidschicht eine Siliziumschicht aus der Gasphase abgeschieden wird, und

c) die Siliziumschicht durch einen anisotropen Ätzprozeß bis auf die an den Flanken der Gatestrukturen verbliebenen Ätzresiduen aus Silizium wieder entfernt wird.

Bei der Anwendung zur Herstellung von optimierten komplementären MOS-Feldeffekttransistoren ist das erfin ungsgemäße Verfahren durch den Ablauf folgender Verfahrensschritte gekennzeichnet:

a) Erzeugung von die aktiven Transistorbereiche trennenden Feldoxidbereichen in bekannter Weise, zum Beispiel nach dem LOCOS-Verfahren, nach dem Einbringen der n-bzw. p-dotierten Wannen in das Substrat,

b) Herstellung des Gateoxids,

c) Abscheidung und Strukturierung der Gate-Elektroden,

d) Durchführung einer Ionenimplantation mit n⁻-dotierenden Ionen zur Erzeugung der Drain-Anschlußgebiete im n-Kanal-Transistorbereich,

e) Abscheidung einer $SiO_2$-Schicht aus der Gasphase und anisotropes Rückätzen dieser Schicht bis auf die an den Flanken der Gate-Strukturen verbliebenen Oxid-Ätzresiduen (1. spacer),

f) Durchführung einer thermischen Oxidation zur Erzeugung einer $SiO_2$-Schicht auf den Gate-und späteren Source/Drain-Diffusionsbereichen,

g) ganzflächige Abscheidung einer Siliziumschicht aus der Gasphase,

h) anisotropes Rückätzen der Siliziumschicht bis auf die an den Flanken der Gatestrukturen verbliebenen Silizium-Ätzresiduen (2. spacer),

i) Durchführung einer ersten Photolacktechnik zur Abdeckung der p-Kanalbereiche,

j) Durchführung der n⁺-Source/Drain-Implantation und Aktivierung der Source/Drain-Gebiete der n-Kanal-Transistoren,

k) Entfernen der Silizium-Ätzresiduen (2. spacer),

l) Durchführung einer zweiten Photolacktechnik zur Abdeckung der n-Kanal-Bereiche,

m) Durchführung der p⁺-Source/Drain-Implantation zur Erzeugung der Source/Drain-Diffusions-Bereiche der p-Kanal-Transistoren und

n) Erzeugung des Zwischenoxides, der Kontaktlochbereiche und der Metallisierung in bekannter Weise.

Das Verfahren zeichnet sich gegenüber den bekannten sidewall-Oxid-spacer-Verfahren dadurch aus, daß bei der Silizium-spacer-Ätzung aufgrund der hohen Ätz-Selektivität zu $SiO_2$ gewährleistet wird, daß einerseits keine wesentliche Feldoxiddünnung folgt und andererseits eine Schädigung des Siliziumsubstrates verhindert wird, da das Gateoxid maskierend wirkt. Bei der Herstellung von CMOS-Transistoren hat dieser spacerTyp gegenüber dem Oxid-spacer den Vorteil, daß durch Entfernung des Silizium-spacers nach der n⁺-Implantation die darauffolgende p⁺-Implantation näher an das Gate gesetzt werden kann als die n⁺-Implantation. Dadurch ist die Herstellung von CMOS-Transistoren mit unterschiedlichen Spacerlängen für n⁺-und p⁺-Implantation möglich, wobei zuerst die n⁺-Implantation erfolgt.

Weitere Ausgestaltungen der Erfindung ergeben sich aus den Unteransprüchen.

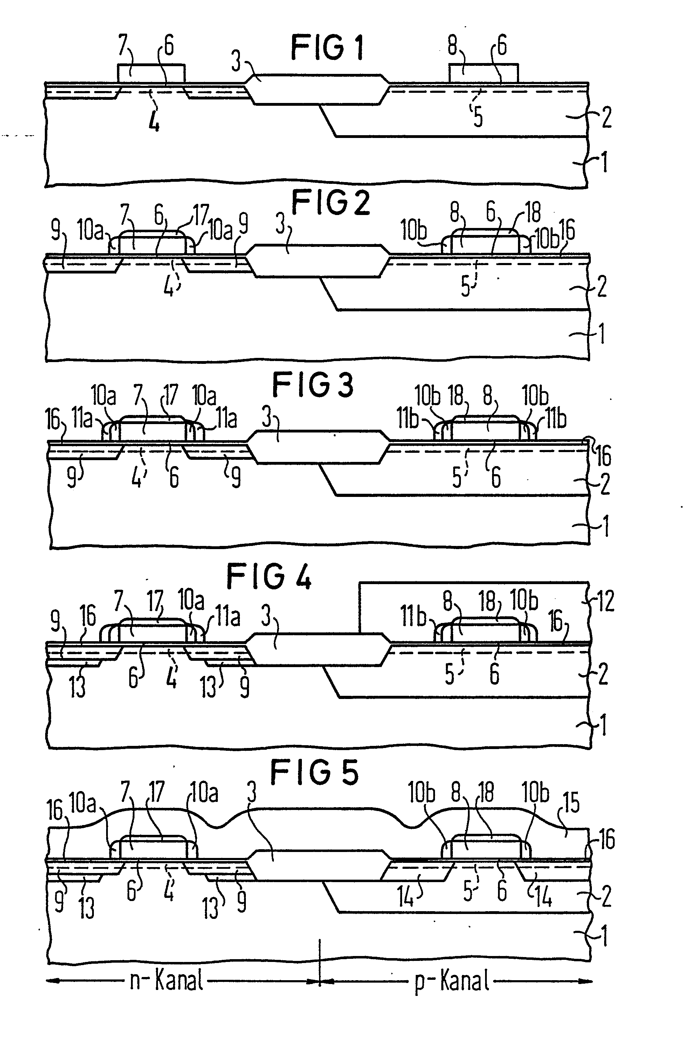

Im folgenden wird anhand eines Ausführungsbeispiels und der Figuren 1 bis 5 der Prozeßablauf zur Herstellung einer sowohl n-Kanal-als auch p-Kanal-Transistoren in einem Substrat enthaltenden Halbleiteranordnung noch näher beschrieben. Dabei sind in den Figuren im Schnittbild nur die erfindungswesentlichen Verfahrensschritte dargestellt; in allen Figuren gelten für gleiche Teile gleiche Bezugszeichen.

Figur 1: In einem herkömmlichen CMOS-Prozeß werden Wannenbereiche und aktive Bereiche definiert. Das Gateoxid der Transistoren wird aufgewachsen, die Kanalimplantation der n-Kanal-und p-Kanal-Transistoren eingebracht und die Gateelektroden, zum Beispiel aus Polysilizium oder einer Doppelschicht aus Polysilizium und Tantalsilizid bestehend, abgeschieden und strukturiert. Den Querschnitt durch einen n-Kanal-und p-Kanal-Transistor zu diesem Zeitpunkt zeigt die Figur 1. Dabei ist mit dem Bezugszeichen 1 das p-dotierte Siliziumsubstrat, mit 2 die n-Wanne für den p-Kanal-Transistor, mit 3 das die aktiven Transistorbereiche trennende Feldoxid, mit 4 und 5 die Kanalimplantation, mit 6 das Gateoxid und mit 7 und 8 die strukturierten Gateelektroden bezeichnet.

Figur 2: Nach Durchführung der n⁻-Anschlußimplantation mit Phosphor-Ionen zur Erzeugung des nieder dotierten Anschlußbereiches 9 des LDD-n-Kanal-Transistors mit der Dosis und Energie von $1 - 2 \times 10^{13}$ cm⁻² und 80 keV wird ganzflächig durch Abscheidung aus der Gasphase (CVD) eine 200 nm dicke $SiO_2$-Schicht (10a, 10b) aufgebracht; dabei ist die Schichtdicke dieser $SiO_2$-Schicht (10a, 10b) der Flankenoxidbreite der Gates 7, 8 angepaßt. Durch ganzflächiges anisotropes Rückätzen der CVD-$SiO_2$-Schicht entstehen dann an den Gates 7 und 8 als Ätzresiduen die Flankenoxidschichten 10a und 10b (1. spacer). Der Ätzprozeß wird durch reaktives Ionenätzen in einem Gemisch aus Trifluormethan und Sauerstoff durchgeführt. Anschließend wird ein Reoxidationsprozeß durchgeführt, wobei auf dem Siliziumsubstrat (1, 4, 5, 9) eine 30 nm dicke $SiO_2$-Schicht 16 und auf dem Tantalsilizid der Gates 7 und 8 eine 80 nm dicke Oxidschicht 17, 18 entsteht.

Figur 3: Nun wird aus der Gasphase (CVD = chemical vapor deposition) ganzflächig und konform eine amorphe Siliziumschicht (11a, 11b) bei 560°C abgeschieden und durch einen anschließenden anisotropen Ätzprozeß in einem Gasgemisch aus Bortrichlorid und Chlor zurückgeätzt, so daß nur an den Flanken der bereits mit den ersten Spacer-oder Maskierschichten 10a, 10b versehenen Gates 7, 8 Ätzresiduen in Form von amorphen Siliziumspacern 11a, 11b (2. spacer) stehenbleiben.

Figur 4: Nach Abdecken des p-Kanalbereiches mit einer ersten Photolackmaske 12 wird die n⁺-Source/Drain-Implantation zur Erzeugung der Source-Drain-Bereiche 13 der n-Kanal-Transistoren mit Arsen-Ionen und einer Dosis und Energie von 6 x 10¹⁵ cm⁻² und 80 keV durchgeführt. Nach Entfernen der Photolackmaske 12 werden die Source/Drain-Bereiche 13 bei 900°C in Stickstoffatmosphäre in 60 Minuten aktiviert.

Figur 5: Jetzt werden die amorphen Siliziumspacer 11a, 11b durch zum Beispiel einen naßchemischen Ätzprozeß in einem Flußsäure/Salpetersäure-Gemisch entfernt und dann unter Verwendung einer zweiten Photolackmaske, die die n-Kanalbereiche abdeckt (nicht dargestellt), in bekannter Weise durch Bor-Ionenimplantation bei einer Dosis und Energie von 4 x 10¹⁵ cm⁻² und 25 keV die Source/Drain-Bereiche 14 der p-Kanal-Transistoren erzeugt. Abschließend erfolgt (nach Entfernung der zweiten Photolackmaske) die Abscheidung einer SiO₂-Zwischenschicht 15 und die Fertigstellung der Anordnung (Kontaktlochbereiche, Metallisierung) in bekannter Weise. Die Aktivierung der Source/Drain-Bereiche 14 erfolgt zusammen mit dem Verfließen der SiO₂-Zwischenschicht 15 bei 900°C in Stickstoffatmosphäre in 40 Minuten.

Wie aus Figur 5 ersichtlich, kann durch das erfindungsgemäße Verfahren eine unterschiedlich weite Rückversetzung der n⁺-bzw. p⁺-Source/Drain-Diffusionsgebiete (13, 14) von der jeweiligen Gatekante (7, 8) erzielt werden. Beim n-Kanal-Transistor ist aus Gründen der Spannungsfestigkeit eine Rückversetzung der n⁺-Implantation um ca. 0,35 μm von der Gatekante erwünscht, während beim p-Kanal-Transistor 0,2 μm nicht überschritten werden sollten, um einen sicheren Anschluß an den Kanalbereich zu gewährleisten. Diese Forderung kann durch das erfindungsgemäße Verfahren, wie eben dargestellt, leicht erfüllt werden.

**Ansprüche**

1. Verfahren zum Herstellen von die Unterdiffusion der implantierten Source/Drain-Bereiche unter die Gateflächen vermindernden Flankenmaskierschichten (spacer) an den Gateelektroden von n-bzw. p-Kanal-MOS-Transistoren mit schwachdotierten Drain-Anschlußgebieten (lightly doped drain = LDD), **dadurch gekennzeichnet, daß**

a) nach der Strukturierung der Gate-Elektroden (7, 8) ganzflächig eine thermische Oxidation durchgeführt wird, wobei die Gate (7, 8)-und die späteren Source/Drain-Diffusionsbereiche (13, 14) der MOS-Transistoren mit einer Oxidschicht (16, 17, 18) versehen werden,

b) ganzflächig auf der Oxidschicht (16, 17, 18) eine Siliziumschicht (11a, 11b) aus der Gasphase abgeschieden wird, und

c) die Siliziumschicht durch einen anisotropen Ätzprozeß bis auf die an den Flanken der Gatestrukturen (7, 8) verbliebenen Ätzresiduen (11a, 11b) aus Silizium wieder entfernt wird.

2. Verfahren nach Anspruch 1, **dadurch gekennzeichnet,** daß die Dicke der thermisch erzeugten Oxidschicht (16, 17, 18) auf 20 bis 100 nm, vorzugsweise 50 nm, eingestellt wird.

3. Verfahren nach Anspruch 1 und/oder 2, **dadurch gekennzeichnet,** daß die Siliziumschicht (11a, 11b) in amorpher Form bei einer Temperatur von 550 bis 600°C abgeschieden wird.

4. Verfahren nach einem der Ansprüche 1 bis 3, **dadurch gekennzeichnet,** daß der anisotrope Ätzprozeß durch reaktives Ionenätzen in einem Gasgemisch aus Bortrichlorid und Chlor durchgeführt wird.

5. Verfahren zum Herstellen von optimierten komplementären MOS-Feldeffekttransistoren (CMOS-Transistoren) in VLSI-Technik, bei dem für die Aufnahme der n-bzw. p-Kanal-Transistoren der Schaltung im Siliziumsubstrat p-bzw. n-dotierte Wannen erzeugt werden, in welche zur Einstellung der verschiedenen Transistoreinsatzspannungen die entsprechenden Dotierstoffatome durch mehrfache Ionenimplantation eingebracht werden, wobei die Maskierung für die einzelnen Ionenimplantationen durch Photolackstrukturen (12) erfolgt, bei dem weiterhin zur Verminderung der Unterdiffusion der implantierten Source/Drain-Bereiche unter die Gatefläche die Gate-Elektroden mit einer Flankenmaskierschicht (spacer) versehen werden und bei dem die Herstellung der Source/Drain-und Gate-Bereiche sowie die Erzeugung des Zwischen- und Isolationsoxids und der Kontaktmetallebene nach bekannten Verfahrensschritten der MOS-Technologie vorgenommen wird, **gekennzeichnet durch** den Ablauf der folgenden Verfahrensschritte:

a) Erzeugung von die aktiven Transistorbereiche trennenden Feldoxidbereichen (3) in bekannter Weise, zum Beispiel nach dem LOCOS-Verfahren, nach dem Einbringen der n-bzw. p-dotierten Wannen (2) in das Substrat (1),

b) Herstellung des Gateoxids (6),

c) Abscheidung und Strukturierung der Gate-Elektroden (7, 8),

d) Durchführung einer Ionenimplantation mit n⁻-dotierenden Ionen zur Erzeugung der Drain-Anschlußgebiete (9) im n-Kanal-Transistorbereich,

e) Abscheidung einer SiO₂-Schicht aus der Gasphase und anisotropes Rückätzen dieser Schicht bis auf die an den Flanken der Gate-Strukturen (7, 8) verbliebenen Oxid-Ätzresiduen (10a, 10b) (1. spacer),

f) Durchführung einer thermischen Oxidation zur Erzeugung einer Oxidschicht (16, 17, 18) auf den Gate-(7, 8) und späteren Source/ Drain-Diffusionsbereichen (13, 14),

g) ganzflächige Abscheidung einer Siliziumschicht (11a, 11b) aus der Gasphase,

h) anisotropes Rückätzen der Siliziumschicht bis auf die an den Flanken der Gatestrukturen (7, 8) verbliebenen Silizium-Ätzresiduen (11a, 11b) (2. spacer),

i) Durchführung einer ersten Photolacktechnik (12) zur Abdeckung der p-Kanalbereiche,

j) Durchführung der n⁺-Source/Drain-Implantation und Aktivierung der Source/Drain-Diffusionsgebiete (13) der n-KanalTransistoren,

k) Entfernen der Silizium-Ätzresiduen (11a, 11b) (2. spacer),

l) Durchführung einer zweiten Photolacktechnik zur Abdeckung der n-Kanal-Bereiche,

m) Durchführung der p⁺-Source/Drain-Implantation zur Erzeugung der Source/Drain-Diffusions-Bereiche (14) der p-Kanal-Transistoren und

n) Erzeugung des Zwischenoxides (15), der Kontaktlochbereiche und der Metallisierung in bekannter Weise.

6. Verfahren nach Anspruch 5, **dadurch gekennzeichnet,** daß die Implantation nach Verfahrensschritt d) mit Phosphor-Ionen bei einer Dosis und Energie von 1 - 2 x $10^{13}$ cm⁻² und 50 - 80 keV durchgeführt wird.

7. Verfahren nach Anspruch 5 und/oder 6, **dadurch gekennzeichnet,** daß die Abscheidung der $SiO_2$-Schicht (10a, 10b) nach Verfahrensschritt e) auf eine Schichtdicke im Bereich von 100 - 200 nm eingestellt wird.

8. Verfahren nach Anspruch 5, **dadurch gekennzeichnet,** daß Verfahrensschritt e) entfällt.

9. Verfahren nach einem der Ansprüche 5 bis 8, **dadurch gekennzeichnet,** daß die thermische Oxidation nach Verfahrensschritt f) so geführt wird, daß auf den späteren Diffusionsbereichen (13, 14) eine Oxidschichtdicke (16) im Bereich von 20 bis 50 nm entsteht.

10. Verfahren nach einem der Ansprüche 5 bis 9, **dadurch gekennzeichnet,** daß die Herstellung der Siliziumschicht (11a, 11b) nach Verfahrensschritt g) in amorpher Form bei 560°C in einer Schichtdicke im Bereich von 150 nm erfolgt.

11. Verfahren nach einem der Ansprüche 5 bis 10, **dadurch gekennzeichnet,** daß die Source/Drain-Implantation der n-Kanal-Transistoren (13) nach Verfahrensschritt j) mit Arsen-Ionen bei einer Dosis und Energie von 6 x $10^{15}$ cm⁻² und 80 keV vorgenommen wird.

12. Verfahren nach einem der Ansprüche 5 bis 11, **dadurch gekennzeichnet,** daß die Source/Drain-Implantation der p-Kanal-Transistoren (14) nach Verfahrensschritt m) mit Bor-Ionen bei einer Dosis und Energie von 4 x $10^{15}$ cm⁻² und 25 keV vorgenommen wird.

13. Verfahren nach einem der Ansprüche 5 bis 12, **dadurch gekennzeichnet,** daß die Entfernung der Silizium-Ätzresiduen (11a, 11b) (2. spacer) nach Verfahrensschritt k) durch reaktives Ionenätzen, zum Beispiel durch Plasma-Ätzen in einem Tetrafluorkohlenstoff-Sauerstoffgasgemisch, oder naßchemisch in einem Gemisch aus Flußsäure, Salpetersäure und Wasser vorgenommen wird.

FIG 1

FIG 2

FIG 3

FIG 4

FIG 5

←——— n-Kanal ———→    ←——— p-Kanal ———→